# EUROPÄISCHE PATENTSCHRIFT

(11) **EP 1 517 333 B1**
(45) Veröffentlichungstag und Bekanntmachung des Hinweises auf die Patenterteilung: **30.12.2009**
(21) Anmeldenummer: 04018551.4
(22) Anmeldetag: 05.08.2004
(51) Int. Cl.: G11C 16/10, G11C 16/16

(54) **Zustandskennzeichen (Flag) für einen bezüglich Löschen und Schreiben asymmetrischen Speicher**
Flag for memory with asymmetry concerning programming and erasure
Drapeau pour mémoire asymétrique avec drapeau indicant l'état concernant la proframmarion et l'éffacement

(30) Priorität: 07.08.2003 DE 10336225
(43) Veröffentlichungstag der Anmeldung: 23.03.2005
(73) Patentinhaber: Giesecke & Devrient GmbH, 81677 München (DE)
(72) Erfinder: Grebe, Alexander, 86150 Augsburg (DE)

(56) Entgegenhaltungen:
- FR-A- 2 725 055
- US-A- 5 996 041
- US-A1- 2003 128 646

## Beschreibung

Die Erfindung betrifft eine Speichereinrichtung mit einem eine Mehrzahl von Speicherzellen aufweisenden, bezüglich des Schreibens und Löschens asymmetrischen elektronischen Speicher mit mindestens einem in dem Speicher implementierten Zustandskennzeichen (Flag), das wahlweise einen ersten (gesetzten, gültigen) Zustandswert oder einen zweiten (nicht gesetzten, ungültigen) Zustandswert haben kann, und das zwischen dem ersten und dem zweiten Zustandswert schaltbar ist.

Ein elektronischer Speicher ist in der Regel in eine Mehrzahl von Speicherzellen unterteilt. Beim Programmieren des Speichers, d.h. Schreiben oder Löschen von Speicherinhalten, werden die einzelnen Speicherzellen von einem ersten Speicherzustand, beispielsweise einer logischen "1 ", in einen zweiten Speicherzustand, beispielsweise eine logische "0", gebracht und umgekehrt, wozu Löschvorgänge und Schreibvorgänge durchgeführt werden. Welcher Zustand von dem gelöschten und dem beschriebenen Speicherzustand dabei eine logische "1" und welcher eine logische "0" ist, ist in der Regel frei wählbar und wird in der Regel bereits durch den Hersteller des Speichers festgelegt.

Eine Mehrzahl von elektronischen Speichern, z.B. EEPROM, Flash-ROM (Flash-EEPROM), sind bezüglich des Schreibens und des Löschens von Daten asymmetrisch, indem beispielsweise die Zeitdauer, die zum Löschen des Speichers erforderlich ist (Löschzeit oder Löschdauer), unterschiedlich ist von der Zeitdauer, die zum Beschreiben des Speichers erforderlich ist (Schreibzeit oder Schreibdauer). Alternativ oder zusätzlich kann der Stromverbrauch beim Schreiben unterschiedlich sein vom Stromverbrauch beim Löschen. Bei einer Mehrzahl von Speichern ist beispielsweise die Programmierspannung, die zum Programmieren angelegt werden muss, unterschiedlich, je nachdem, ob der Speicher beschrieben oder gelöscht wird. Unter der Programmierspannung ist hierbei die tatsächlich bei der Speicherzelle anliegende Spannung zu verstehen, die von einer äußeren, von einer Spannungsquelle erzeugten Spannung, die zur Erzeugung der Programmierspannung verwendet wird, unterschiedlich sein kann.

Bei einem bekannten Flash-EEPROM-Speicher vom Typ NOR-Flash des Herstellers Silicon Storage Technology SST ist für eine einzelne Speicherzelle "1" ("Eins") der gelöschte Zustand und "0" ("Null") der beschriebene Zustand. Bei diesem Flash-EEPROM dauert das Schreiben, bei dem einzelne Speicherzellen von logisch "1" auf logisch "0" umprogrammiert werden, ungefähr 50 µs, wohingegen das Löschen von Speicherzellen, das beim Flash-Speicher i.d.R. in Einheiten von Pages oder Blocks durchgeführt wird, und bei dem die Speicherzellen von logisch "0" auf logisch "1" umprogrammiert werden, ungefähr zwei bis maximal fünf ms dauert.

Für unterschiedliche Operationen, wie beispielsweise Programmiervorgänge, in einem Speicher ist es erforderlich, dass der Zustand eines vorbestimmten Speicherabschnitts bekannt ist, damit beispielsweise der Zustand als Bedingung für nachfolgende Operationsschritte verwendet werden kann. Der Zustand des Speicherabschnitts ist hierbei durch ein Zustandskennzeichen oder gleichbedeutend Flag markiert. In Abhängigkeit vom Zustandswert (Flag-Wert) kann beispielsweise das Schreiben (oder das Lesen) in dem Speicherabschnitt entweder verboten oder erlaubt sein. Gegenstand der Erfindung ist ein Zustandskennzeichen oder Flag in diesem Sinne, also ein Kennzeichen durch das ein Zustand angezeigt ist.

Flags werden beispielsweise häufig bei sogenannten atomaren Schreibvorgängen benutzt, die sich dadurch auszeichnen, dass sie nur entweder vollständig oder gar nicht ausgeführt werden dürfen. Ein Beispiel für einen solchen atomaren Schreibvorgang stellt das Schreiben von Daten in eine Chipkarte dar, beispielsweise um einen Fehlbedienungszähler zu aktualisieren oder um eine elektronische Geldbörse mit einer Zahlung zu belasten (Rankl, Effing, Handbuch der Chipkarten, 4. Auflage, Carl Hanser Verlag München Wien, 2002, Kapitel 5.10 "Atomare Abläufe", S. 293-295). Sollen neue Daten in einen Speicherabschnitt der Chipkarte geschrieben werden, so werden zuerst die ursprünglichen Daten, die vor dem Schreiben in dem Speicherabschnitt gespeichert sind, in einen nichtflüchtigen Pufferspeicher der Chipkarte kopiert (z.B. in einen EEPROM-Speicher der Chipkarte). Sobald der Kopiervorgang erfolgreich durchgeführt ist, wird das Zustandskennzeichen (Flag) des Pufferspeichers gesetzt oder, gleichbedeutend, auf "gültig" (="gesetzt") geschaltet, was bedeutet, dass die Daten im Pufferspeicher als gültig angesehen werden. Das Zustandskennzeichen oder Flag hat in diesem Fall einen gültigen Zustandswert. Anschließend werden die neuen Daten (z.B. neuer Geldbetrag in der elektronischen Geldbörse, der gleich dem ursprünglich vorhandenen Geldbetrag verringert um den zu zahlenden Betrag ist) in den Speicherabschnitt geschrieben. Sobald die neuen Daten erfolgreich in den Speicherabschnitt geschrieben worden sind, wird das Zustandskennzeichen (Flag) des Pufferspeichers gelöscht oder, gleichbedeutend, auf "ungültig" (= "gelöscht", "nicht gesetzt") geschaltet, was bedeutet, dass die Daten im Pufferspeicher als ungültig angesehen werden und nicht mehr verwendet werden sollen.

Kommt es nun, abweichend vom vorstehend beschriebenen Fall, in dem der atomare Schreibvorgang erfolgreich vollständig durchgeführt worden ist, während des Ablaufs des Schreibvorgangs zu einem Abbruch, verursacht beispielsweise durch eine Unterbrechung der Betriebsspannung, so kann bei der nächsten Inbetriebnahme der Chipkarte das Zustandskennzeichen (Flag) dabei verwendet werden, den Speicherinhalt des Speicherabschnitts der Chipkarte bei Bedarf wiederherzustellen. Falls das Zustandskennzeichen (Flag) des Pufferspeichers gesetzt, d.h. "auf gültig gesetzt", ist, werden die Daten aus dem Pufferspeicher, d.h. die ursprünglichen Daten, wieder in den Speicherabschnitt geschrieben, da zuvor die neuen Daten noch nicht vollständig einprogrammiert worden sind. Die neuen Daten müssen nochmals eingeschrieben werden. Im Fall einer elektronischen Geldbörse wird also der Geldbetrag, der vor dem teilweise fehlgeschlagenen Belastungsvorgang (Verringerung des Geldbetrags) dort vorhanden war, in der elektronischen Geldbörse wiederhergestellt. Die Belastung muss nochmals vorgenommen werden. Falls hingegen das Zustandskennzeichen (Flag) des Pufferspeichers gelöscht, d.h. nicht gesetzt oder "auf ungültig gesetzt", ist, zeigt dies an, dass die Daten zuvor vollständig in den Speicherabschnitt geschrieben worden sind. Die ursprünglichen Daten im Pufferspeicher werden daher nicht zurück in den Speicherabschnitt geschrieben. Im Beispiel der elektronischen Geldbörse wird der neue, verringerte Geldbetrag beibehalten.

Zustandskennzeichen (Flags) werden außer bei atomaren Schreibvorgängen und Lesevorgängen auch bei einer Vielzahl von weiteren unterschiedlichen Operationen eingesetzt.

Ein herkömmliches Zustandskennzeichen (Flag) besteht aus einer einzelnen Speicherzelle, z.B. einem einzelnen Bit, die auf Null "0" oder Eins "1" gesetzt ist, je nachdem, ob der Zustandswert des Zustandskennzeichens (Flags) gültig (Flag gesetzt) oder ungültig (Flag nicht gesetzt) ist.

Bei einem Speicher, der bezüglich des Schreibens (Schreibvorgänge) und des Löschens (Löschvorgänge) asymmetrisch ist, hat ein solches Zustandskennzeichen (Flag) aus einer einzelnen Speicherzelle den Nachteil, dass das Zustandskennzeichen bezüglich des Schaltens, d.h. bezüglich des Setzens (auf gültig Setzens) und Löschens (auf ungültig Setzens) des Zustandskennzeichens asymmetrisch ist.

Beispielsweise muss zum Setzen des Zustandskennzeichens (Flags) ein anderer, unterschiedlicher Spannungswert an die Speicherzelle angelegt werden als zum Löschen des Zustandskennzeichens (Flags). Alternativ oder zusätzlich sind die Programmierdauern für das Setzen und Löschen des Zustandskennzeichens (Flags) unterschiedlich. In beiden Fällen ist die Ansteuerelektronik zum Schalten, d.h. Setzen bzw. Löschen, des Zustandskennzeichens (Flags) aufwändig und daher teuer, da sie eine Fallunterscheidung vornehmen muss, ob ein Schreibvorgang oder ein Löschvorgang durchgeführt werden soll.

Aus US 2003/128646 A1 ist eine Speichereinrichtung bekannt. Die Speicherzellen enthalten ein Material, das einen amorphen und einen kristallinen Zustand einnehmen kann, von denen der eine dem beschriebenen und der andere dem gelöschten Zustand entspricht. Dadurch, dass ein Schalten des Materials vom amorphen in den kristallinen Zustand unterschiedlich lange dauert als umgekehrt, ist der Speicher asymmetrisch bezüglich Schreibvorgängen und Löschvorgängen.

Eine Speichereinrichtung nach dem Oberbegriff der Ansprüche 1 und 16 ist aus der US 5996041 bekannt.

Aufgabe der Erfindung ist es, eine Speichereinrichtung der eingangs genannten Art zu schaffen, die ein effizienteres Schalten des Zustandskennzeichens ermöglicht, und ein entsprechendes Kennzeichnungsverfahren unter Verwendung eines Zustandskennzeichen zu schaffen.

Die Aufgabe wird gelöst durch eine Speichereinrichtung nach dem unabhängigen Anspruch 1 und durch ein Verfahren nach dem unabhängigen Anspruch 16. Vorteilhafte Ausgestaltungen der Erfindung sind in den abhängigen Ansprüchen angeführt.

Die erfindungsgemäße Speichereinrichtung gemäß dem unabhängigen Anspruch 1, bzw. das erfindungsgemäße Verfahren gemäß dem unabhängigen Anspruch 16, hat, bzw. bezieht sich auf einen elektronischen Speicher mit einer Mehrzahl von binären Speicherzellen. Jede Speicherzelle ist durch einen Programmiervorgang zwischen einem gelöschten und einem beschriebenen Zustand schaltbar, wobei durch einen Löschvorgang der gelöschte Zustand herstellbar ist und durch einen Schreibvorgang der beschriebene Zustand herstellbar ist. Der Speicher ist bezüglich Schreibvorgängen und Löschvorgängen asymmetrisch, wobei dies genauer bedeutet, dass bei einem Schreibvorgang ein oder mehrere Programmierparameter einen anderen (unterschiedlichen) Wert haben als bei einem Löschvorgang. Zu den Programmierparametern können zählen: die Programmierdauer, d.h. die Zeitdauer, die erforderlich ist, um einen vollständigen Programmiervorgang, insbesondere Schreibvorgang oder Löschvorgang, durchzuführen; die Programmierspannung, d.h. die Spannung, die an den Speicher, insbesondere an jede einzelne Speicherzelle, angelegt werden muss, um einen Programmiervorgang durchzuführen.

In dem Speicher ist weiter mindestens ein Zustandskennzeichen (Flag) implementiert, das wahlweise einen ersten (gesetzten, gültigen) Zustandswert oder einen zweiten (gelöschten, ungültigen, nicht gesetzten) Zustandswert haben kann. Weiter weist die Speichereinrichtung eine Schalteinrichtung auf, mit der der Wert des Zustandskennzeichens zwischen dem ersten und dem zweiten Zustandswert schaltbar ist, wobei zum Schalten des Zustandswerts mindestens ein Programmiervorgang an mindestens einer Speicherzelle durchgeführt wird. Gemäß der Erfindung ist die Schalteinrichtung, mit der sich der Wert des Zustandskennzeichens schalten, d.h. wahlweise setzen und löschen, lässt, derart implementiert, dass zum Schalten vom ersten zum zweiten Zustandswert und zum Schalten vom zweiten zum ersten Zustandswert die gleiche Art von Programmiervorgang, insbesondere Schreibvorgang oder Löschvorgang, durchgeführt wird. Insbesondere wird beispielsweise sowohl zum Setzen des Flag als auch zum Löschen des Flag ein Schreibvorgang an einer Speicherzelle durchgeführt. Alternativ wird sowohl zum Setzen des Flag als auch zum Löschen des Flag ein Löschvorgang an einer Speicherzelle durchgeführt.

Die erfindungsgemäße Speichereinrichtung hat den Vorteil, dass das Zustandskennzeichen (Flag) bezüglich seines Setzens und Löschens symmetrisch ist. D.h. insbesondere haben die ein oder mehreren Programmierparameter wie Programmierdauer und/ oder Programmierspannung beim Löschen und beim Setzen den gleichen Wert. Hierdurch braucht keine Fallunterscheidung danach getroffen werden, ob das Zustandskennzeichen (Flag) gesetzt oder gelöscht wird, so dass eine Schalteinrichtung mit einem einfachen Aufbau verwendet werden kann. Das Schalten des Zustandskennzeichens ist hierdurch effizienter als bei bekannten Speichereinrichtungen.

Daher ist gemäß Anspruch 1 eine Speichereinrichtung geschaffen, die ein effizienteres Schalten des Zustandskennzeichens ermöglicht.

Vorzugsweise wird zum Setzen und zum Löschen des Zustandskennzeichens (Flag) jeweils genau ein Programmiervorgang an genau einer Speicherzelle durchgeführt.

Der Speicher kann insbesondere beispielsweise ein (gewöhnlicher) EEPROM oder ein Flash-EEPROM (Flash-ROM) sein, der im genannten Sinn asymmetrisch ist.

Die Komponenten der erfindungsgemäßen Speichereinrichtung, wie das Zustandskennzeichen und die Schalteinrichtung, können in Softwareform, in Hardwareform oder teils in Softwareform, teils in Hardwareform implementiert sein. Vorzugsweise sind das Zustandskennzeichen und die Schalteinrichtung und ggf. weitere Komponenten in Softwareform implementiert.

Die Asymmetrie bezüglich Schreibvorgängen und Löschvorgängen umfasst gemäß einer Ausführungsform der Erfindung, dass ein Schreibvorgang eine kürzere Programmierdauer hat (kürzer dauert) als ein Löschvorgang oder umgekehrt. Vorzugsweise wird bei dieser Ausführungsform von der Schalteinrichtung zum Schalten zwischen dem ersten und zweiten Zustandswert des Zustandskennzeichens (Flag) derjenige Programmiervorgang von dem Schreibvorgang und dem Löschvorgang verwendet wird, der eine kürzere Programmierdauer hat. Diese bevorzugte Ausführungsform hat den weiteren Vorteil, dass das Zustandskennzeichen zum Schalten seines Zustandswerts nur "schnelle" Programmiervorgänge verwendet. Hierdurch ist das Zustandskennzeichen besonders zeitsparend und daher effizient.

Gemäß einer anderen Ausführungsform der Erfindung umfasst die Asymmetrie bezüglich Schreibvorgängen und Löschvorgängen, dass ein Schreibvorgang eine andere, unterschiedliche (höhere oder niedrigere) Programrnierspannung benötigt als ein Löschvorgang. Vorzugsweise wird beim Schalten des Zustandskennzeichens derjenige Programmiervorgang verwendet, der die niedrigere Programmierspannung benötigt. Diese bevorzugte Ausführungsform hat den weiteren Vorteil, dass das Zustandskennzeichen beim Schalten seines Zustandswerts besonders stromsparend ist.

Vorzugsweise hat die Speichereinrichtung weiter eine Rücksetzeinrichtung, mit der ein Ausgangszustand des Zustandskennzeichens einstellbar ist. Ausgehend vom Ausgangszustand ist mindestens ein Schaltvorgang zum Schalten, insbesondere Setzen oder Löschen, des Zustandskennzeichens (Flag) möglich. Vorzugsweise, in Abhängigkeit von der genaueren Gestaltung des Zustandskennzeichens, ist ausgehend vom Ausgangszustand eine Mehrzahl von aufeinanderfolgenden Schaltvorgängen möglich, bei denen der Zustandswert des Zustandskennzeichens abwechselnd zwischen gültig und ungültig geschaltet wird, d.h. abwechselnd immer einmal von ungültig zu gültig und einmal von gültig zu ungültig geschaltet wird. Dabei wird, gemäß der Erfindung, zum Schalten jeweils die gleiche Art von Programmiervorgang verwendet, unabhängig davon, ob das Zustandskennzeichen auf gültig oder auf ungültig geschaltet wird.

Die Rücksetzeinrichtung ist weiter vorzugsweise derart implementiert, dass sie zum Einstellen des Ausgangszustands den anderen Programmiervorgang von dem Schreibvorgang und dem Löschvorgang verwendet, als er zum Schalten zwischen dem ersten und dem zweiten Zustandswert des Zustandskennzeichens (Flag) verwendet wird.

Beispielsweise wird also zum Schalten des Zustandskennzeichens (Flag) ein Schreibvorgang an einer Speicherzelle verwendet und zum Einstellen des Ausgangszustands mittels der Rücksetzeinrichtung ein Löschvorgang verwendet oder umgekehrt.

Gemäß einer bevorzugten Ausführungsform wird zum Schalten des Zustandskennzeichens (Flag) der schnellere Programmiervorgang verwendet, bei dem die Programmierdauer niedriger ist, wohingegen zum Einstellen des Ausgangszustands mittels der Rücksetzeinrichtung der langsamere Programmiervorgang verwendet wird, bei dem die Programmierdauer höher ist. Diese Ausführungsform hat den weiteren Vorteil, dass der langsame Programmiervorgang ausschließlich beim Rücksetzen angewandt wird, das in der Regel seltener durchgeführt wird als das Schalten des Zustandskennzeichens (Flag). Beim in der Regel häufiger durchgeführten Schalten des Zustandskennzeichens (Flag), d.h. beim Setzen und Löschen, wird der schnelle Programmiervorgang verwendet.

Alternativ oder zusätzlich wird zum Schalten des Zustandskennzeichens (Flag) der stromsparendere Programmiervorgang verwendet, bei dem eine geringere Programmierspannung an die Speicherzelle(n) angelegt werden muss, wohingegen zum Einstellen des Ausgangszustands mittels der Rücksetzeinrichtung der stromintensivere Programmiervorgang verwendet wird, bei dem eine höhere Programmierspannung an die Speicherzelle(n) angelegt werden muss. Hierdurch ist der stromintensive Programmiervorgang nur bei dem selteneren Rücksetzen des Zustandskennzeichens (Flag) im Einsatz, beim Schalten (Setzen, Löschen) des Zustandskennzeichens (Flag) wird dagegen der stromsparende Programmiervorgang verwendet.

Eine bevorzugte Verwendung der Speichereinrichtung gemäß der Erfindung ist in einem Datenträger wie einer Chipkarte oder einem Token, mit einem elektronischen Schaltkreis, in dem die Speichereinrichtung implementiert ist. Die Chipkarte kann eine kontaktlose oder kontaktbehaftete oder sowohl kontaktlos als auch kontaktbehaftet betreibbare Chipkarte mit einem beliebigen Format, z.B. nach ISO 7810, z.B. ID-1 (Scheckkartenformat) oder ID-000 (SIM-Karten- oder Minikarten-Format) oder ID-00 oder nach GSM 11.1 oder TS 102.221 oder nach einer anderen Norm, oder nach keiner Norm. Der Token kann jedes beliebige Gehäuse und jede beliebige Schnittstelle (kontaktlos, kontaktbehaftet, seriell, USB etc.) haben.

Im folgenden wird die Erfindung an Hand von Ausführungsbeispielen und unter Bezugnahme auf die Zeichnung näher erläutert, in der zeigen:
- Fig. 1: ein Zustandskennzeichen (Flag) gemäß einer Ausführungsform der Erfindung, mit zwei Bitfeldern B1, B2;
- Fig. 2: den Verfahrensablauf beim Schreiben (Kopieren) von neuen Daten in eine Datei, mit vorherigem Puffern der ursprünglichen Daten in der Datei, gemäß einer Verwendung der Erfindung;
- Fig. 3: eine schematische Darstellung der Kopiervorgänge der ursprünglichen Daten von der Datei in den Pufferspeicher und der neuen Daten in die Datei, bei dem Verfahren aus Fig. 2;
- Fig. 4: die Funktionsweise einer XOR-Logikeinheit zur Ermittlung des Zustandswerts eines Flag am Beispiel eines gültigen (gesetzten) Flag;
- Fig. 5: die Funktionsweise der XOR-Logikeinheit aus Fig. 4 am Beispiel eines ungültigen (nicht gesetzten, gelöschten) Flag.

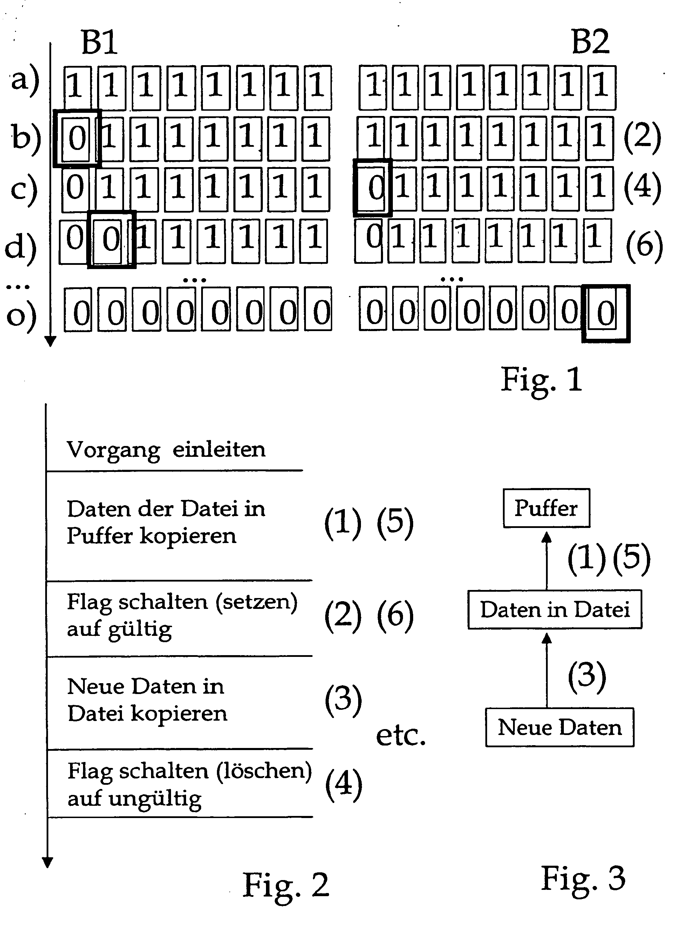

Gemäß Ausführungsformen der Erfindung hat das Zustandskennzeichen mindestens ein Paar von zwei Teilkennzeichen, wobei jedes Teilkennzeichen des Paars mindestens eine Speicherzelle aufweist. Das Zustandskennzeichen aus Fig. 1, das weiter unten noch genauer beschrieben ist, bildet eine Spezialform eines solchen Zustandskennzeichens, bei der insbesondere jedes Teilkennzeichen des Paars die gleiche Anzahl von Speicherzellen aufweist, insbesondere acht. Die Teilkennzeichen aus Fig. 1 sind aus einzelnen Speicherzellen gebildet, wobei jede Speicherzelle ein Bit groß ist, so dass jedes Teilkennzeichen als Bitfeld B1 bzw. B2 ausgebildet ist. Alternativ können die einzelnen Speicherzellen eine andere Größe als Bit haben, beispielsweise kann jede Speicherzelle zwei Bit oder ein Byte groß sein. Die Anzahl von Speicherzellen pro Teilkennzeichen bzw. Bitfeld kann außerdem höher oder niedriger als acht sein. Zudem kann die Anzahl von Speicherzellen pro Teilkennzeichen/ Bitfeld, anders als in Fig. 1 gezeigt, unterschiedlich sein. Vorzugsweise ist die Anzahl von Speicherzellen in beiden Teilkennzeichen gleich, da in diesem Fall ein abwechselndes Schalten des Zustandskennzeichens (Flag) in den beiden Teilkennzeichen/ Bitfeldern bis zur letzten Speicherzelle möglich ist.

Ein erfindungsgemäßer Flash-Speicher mit dem Zustandskennzeichen mit den beiden Teilkennzeichen ist vorzugsweise in Pages eingeteilt, wobei beim Löschen des Speichers jeweils eine Pages auf einmal gelöscht wird. Jedes der beiden Teilkennzeichen hat bei dem Flash-Speicher vorzugsweise eine Anzahl von Speicherzellen, die gleich einem ganzzahligen Teiler der Pagegröße (Anzahl Speicherzellen pro Page) ist, so dass also eine einzelne Page durch eine ganze Zahl von Teilkennzeichen vollständig gefüllt werden kann. Weiter vorzugsweise ist die Größe des Teilkennzeichens (Anzahl Speicherzellen im Teilkennzeichen) gleich einem ganzzahligen Teiler der halben Pagegröße ist, so dass also eine einzelne Page durch eine ganze Zahl von Zustandskennzeichen mit je zwei Teilkennzeichen vollständig gefüllt werden kann.

Bei einer bevorzugten Ausführungsform eines Zustandskennzeichens mit einem Paar von (zwei) Teilkennzeichen ist der erste Zustandswert dadurch ausgezeichnet, dass in jedem Teilkennzeichen des Paars die gleiche Anzahl von Speicherzellen den gelöschten und/oder den beschriebenen Zustand hat, wobei der zweite Zustandswert bei dieser Ausführungsform dadurch ausgezeichnet ist, dass in jedem Teilkennzeichen des Paars eine unterschiedliche Anzahl von Speicherzellen den gelöschten und/ oder den beschriebenen Zustand hat. Weiter vorzugsweise bilden die einzelnen Speicherzellen des ersten Teilkennzeichens mit den einzelnen Speicherzellen des zweiten Teilkennzeichens Paare von korrespondierenden Speicherzellen, d.h. die erste (zweite, dritte, vierte, ...) Speicherzelle des ersten Teilkennzeichens korrespondiert mit der ersten (zweiten, dritten, vierten, ...) Speicherzelle des zweiten Teilkennzeichens. Bei dieser bevorzugten Variante ist der erste Zustandswert dadurch ausgezeichnet, dass in den beiden Teilkennzeichen korrespondierende Speicherzellen den gleichen Zustand haben, und der zweite Zustandswert dadurch ausgezeichnet, dass in den beiden Teilkennzeichen bei einem Paar von korrespondierenden Speicherzellen die beiden korrespondierenden Speicherzellen einen unterschiedlichen Zustand haben.

Fig. 1 zeigt ein Zustandskennzeichen (Flag) gemäß einer bevorzugten Ausführungsform der Erfindung. Das Zustandskennzeichen (Flag) besteht aus zwei Bitfeldern B1, B2 mit je acht Bit.

Die erste Zeile a) von Fig. 1 zeigt das Zustandskennzeichen (Flag) in seinem Ausgangszustand, in dem es sich nach einem Rücksetzen mittels der Rücksetzeinrichtung befindet, ohne dass es nach dem Rücksetzen nochmals geschaltet worden ist. Alle Bits haben den logischen Wert "1 ", so dass beide Bitfelder B1, B2 die gleiche Anzahl von acht "Einsen" und null "Nullen" haben. Zugleich hat jedes Paar von korrespondierenden Bits (Speicherzellen) der beiden Bitfelder B1, B2 den gleichen Zustand, d.h. das erste Bit (von links) des ersten Bitfeldes B1 hat den gleichen Zustand wie das erste Bit (von links) des zweiten Bitfeldes B2, das zweite Bit (von links) des ersten Bitfeldes B1 hat den gleichen Zustand wie das zweite Bit (von links) des zweiten Bitfeldes B2, das dritte Bit (von links) des ersten Bitfeldes B1 hat den gleichen Zustand wie das dritte Bit (von links) des zweiten Bitfeldes B2 etc.. Der Zustandswert des Zustandskennzeichens (Flag) ist nicht gültig, d.h. das Flag ist gelöscht, d.h. nicht gesetzt.

Die zweite Zeile b) von Fig. 1 zeigt das Zustandskennzeichen, nachdem es gesetzt worden ist, d.h. nachdem sein Zustandswert auf "gesetzt" geschaltet worden ist. Zum Schalten ist das erste Bit des ersten Bitfeldes B1 (eingerahmt) von "1" auf "0" geschaltet worden. Das Bitfeld B1 hat nun sieben Einsen und eine Null. Das Bitfeld B2 hat dagegen acht Einsen und keine Null. Daher haben die beiden Bitfelder B1, B2 eine unterschiedliche Anzahl von Einsen bzw. Nullen. Der Zustandswert des Zustandskennzeichens ist folglich gültig oder gesetzt. Zugleich hat das erste Bit des ersten Bitfeldes B1 (Zustandswert "0") einen anderen Zustand als das erste Bit des zweiten Bitfeldes B2 (Zustandswert "1"). Bei dem ersten Paar von korrespondierenden Bits (Speicherzellen) ist somit der Zustand unterschiedlich. Daher ist bei der Ausführungsform aus Fig. 1 das Zustandskennzeichen (Flag) auch gemäß diesem Kriterium gesetzt (gültig).

Die dritte Zeile c) von Fig. 1 zeigt das Zustandskennzeichen, nachdem es, anschließend an das Setzen aus Zeile b), wieder gelöscht worden ist, d.h. nachdem sein Zustandswert auf nicht gesetzt (gelöscht) geschaltet worden ist. Hierzu ist das erste Bit des zweiten Bitfeldes B2 (eingerahmt) von "1" auf "0" geschaltet worden. Das erste Bitfeld B1 hat nach wie vor sieben Einsen und eine Null. Das zweite Bitfeld B2 hat nun ebenfalls sieben Einsen und eine Null. Daher haben die beiden Bitfelder B1, B2 die gleiche Anzahl von Einsen bzw. Nullen. Der Zustandswert des Zustandskennzeichens ist folglich ungültig oder nicht gesetzt. Zugleich haben in Zeile c) von Fig. 1 das erste Bit des ersten Bitfeldes B1 und das erste Bit des zweiten Bitfeldes B2 (wieder) den gleichen Zustand. Das erste Paar von korrespondierenden Bits (Speicherzellen) hat also (wieder) den gleichen Zustand, so dass alle korrespondierenden Bits (Speicherzellen) den gleichen Zustand haben.

Die vierte Zeile d) von Fig. 1 zeigt das Zustandskennzeichen, nachdem es, anschließend an das Löschen aus Zeile c), wieder gesetzt worden ist. Hierzu ist das zweite Bit des ersten Bitfeldes B1 (eingerahmt) von "1" auf "0" geschaltet worden. Daher haben die beiden Bitfelder B1, B2 eine unterschiedliche Anzahl von Einsen bzw. Nullen. Der Zustandswert des Zustandskennzeichens ist folglich ungültig oder nicht gesetzt. Zugleich haben in Zeile d) von Fig. 1 das zweite Bit des ersten Bitfeldes B1 (eingerahmt, Zustandswert "0") und das zweite Bit des zweiten Bitfeldes B2 (Zustandswert "1 ") einen unterschiedlichen Zustand. Die korrespondierenden zweiten Bits der beiden Bitfelder B1, B2 haben somit einen unterschiedlichen Zustand. Alle anderen korrespondierenden Paare (erstes, drittes, viertes, ... achtes korrespondierendes Paar) von Bits haben jeweils den gleichen Zustand, nämlich links vom aktuellen (hier zweiten) Bit mit Zustandswert "1", rechts davon mit Zustandswert "0".

Nachfolgend kann das Zustandskennzeichen noch sechs Mal gesetzt und sieben Mal gelöscht werden, insgesamt also acht Mal, d.h. so oft wie jedes Bitfeld Bits hat, gesetzt und gelöscht werden. Dabei wird jeweils abwechselnd ein Bit im ersten Bitfeld B1 und ein Bit im zweiten Bitfeld B2 geschaltet. Innerhalb jedes einzelnen Bitfeldes B1 oder B2 werden die benachbarten Bits der Reihe nach geschaltet, d.h. erst das erste Bit, dann das zweite Bit, dann das dritte Bit, dann das vierte Bit etc.. Als letztes Bit wird, wie in der letzten Zeile o) von Fig. 1 dargestellt ist, das letzte Bit (eingerahmt) des zweiten Bitfeldes B2 geschaltet. Erst dann sind alle Bits auf "Null" gesetzt, und das Zustandskennzeichen muss wieder zurückgesetzt werden (Reset), um den in Zeile a) von Fig. 1 gezeigten Zustand wiederherzustellen.

Um bei einem Zustandskennzeichen mit zwei Teilkennzeichen, also insbesondere bei einem Zustandskennzeichen mit zwei Bitfeldern wie dem in Fig. 1 dargestellten, aus der Konfiguration der Teilkennzeichen (Bitfelder) einen Zustandswert des Zustandskennzeichens (Flag) zu ermitteln, hat die Speichereinrichtung gemäß einer Ausführungsform der Erfindung eine Logikeinheit, insbesondere eine XOR-Logikeinheit. Die Logikeinheit ist dazu eingerichtet, korrespondierende Speicherzellen des ersten und des zweiten Teilkennzeichens zu verknüpfen und das Ergebnis der Verknüpfung als Zustandswert des Zustandskennzeichens auszugeben.

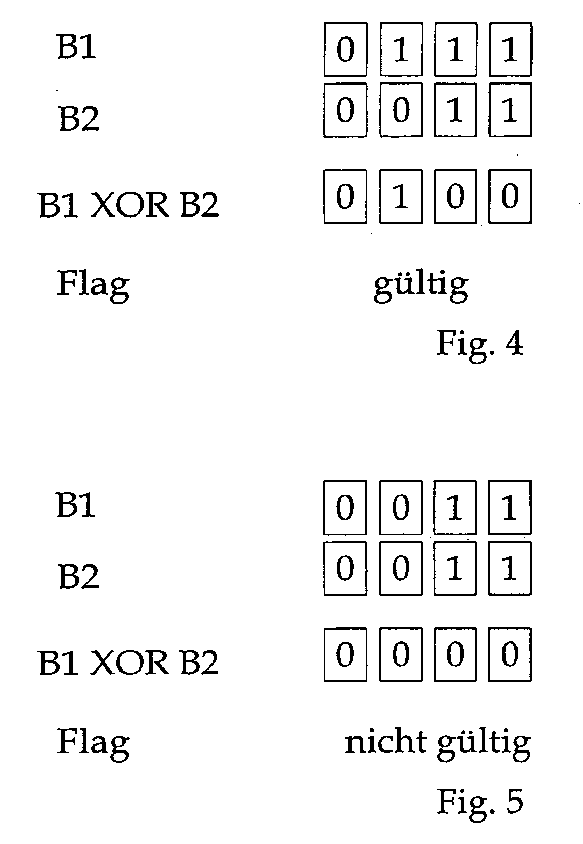

Fig. 4 und Fig. 5 veranschaulichen die Funktionsweise einer erfindungsgemäßen Logikeinheit in Form einer XOR-Logikeinheit. Fig. 4 zeigt dabei die Funktionsweise einer XOR-Logikeinheit am Beispiel eines gültigen (gesetzten) Flag. Fig. 5 zeigt die Funktionsweise der XOR-Logikeinheit am Beispiel eines ungültigen (nicht gesetzten, gelöschten) Flag. Die ersten beiden Zeilen der Figuren 4 und 5 zeigen jeweils ein Zustandskennzeichen (Flag) mit zwei Bitfeldern B1 und B2 nach einer ähnlichen Ausführungsform des Zustandskennzeichens wie der in Fig. 1 gezeigten, jedoch mit nur vier Bits pro Bitfeld B1, B2.

Das Flag aus Fig. 4 ist gesetzt (gültig), da das zweite Bit des ersten Speicherfelds B1 den Zustandswert "1" hat und das zweite Bit des zweiten Speicherfelds B2 den Zustandswert "0" hat, so dass also die beiden korrespondierenden zweiten Bits unterschiedliche Zustandswerte haben. Die bitweise XOR-Verknüpfung der beiden Bitfelder ergibt die in der dritten Zeile dargestellte Bitfolge. Da eines der vier Bits, hier das zweite Bit, von Null unterschiedlich ist, gilt das Flag als gesetzt (gültig), wie in der vierten Zeile dargestellt ist. Das Flag gülte auch dann als gesetzt, wenn in der dritten Zeile ein anderes von den vier Bits, also das erste, dritte oder vierte Bit, von Null unterschiedlich wäre (in Fig. 4 nicht gezeigt).

Das Flag aus Fig. 5 ist nicht gesetzt (ungültig), da alle vier Paare von korrespondierenden Bits den gleichen Zustandswert haben, nämlich "Null" für die beiden korrespondierenden ersten Bits und die beiden korrespondierenden zweiten Bits, sowie "Eins" für die beiden korrespondierenden dritten Bits und die beiden korrespondierenden vierten Bits. Die bitweise XOR-Verknüpfung der beiden Bitfelder ergibt die in der dritten Zeile dargestellte Bitfolge. Da alle Bits Null sind, gilt das Flag als nicht gesetzt (ungültig), wie in der vierten Zeile dargestellt ist.

Fig. 2 zeigt, gemäß einer Ausführungsform der Erfindung, den Verfahrensablauf beim Schreiben (Kopieren) von neuen Daten in eine Datei, mit vorherigem Puffern der ursprünglichen Daten, die ursprünglich in der Datei vorhanden waren. Fig. 3 zeigt schematisch den zeitlichen und räumlichen Ablauf der Kopiervorgänge bei dem Verfahren aus Fig. 2.

Zu Beginn des Verfahrens enthält eine Datei ursprüngliche Daten. Nun sollen in die Datei neue Daten kopiert und dort abgespeichert werden, wobei die ursprünglichen Daten überschrieben werden. Zum Puffern der ursprünglichen Daten steht ein Pufferspeicher zur Verfügung, der ein Flag hat, mit dem die Daten im Pufferspeicher als gültig oder ungültig markiert werden können. Nachdem der Vorgang eingeleitet worden ist, werden in einem ersten Schritt (1) die ursprünglichen Daten der Datei in den Pufferspeicher kopiert (Fig. 2, Fig. 3). Anschließend wird, in einem zweiten Schritt (2), das Flag des Pufferspeichers auf gültig gesetzt (Fig. 2). Dies kann beispielsweise durch einen Schaltvorgang (2) wie den in Zeile b) von Fig. 1 gezeigten durchgeführt werden, bei dem das erste Bit des ersten Bitfeldes B1 geschaltet wird. In einem dritten Schritt (3) werden die neuen Daten in die Datei kopiert und dort abgespeichert (Fig. 2, Fig. 3). Sobald der dritte Schritt erfolgreich vollendet ist, wird in einem vierten Schritt (4) das Flag des Pufferspeichers auf ungültig gesetzt (Fig. 2). Dies kann beispielsweise durch einen Schaltvorgang (4) wie den in Zeile c) von Fig. 1 gezeigten durchgeführt werden, bei dem das erste Bit des zweiten Bitfeldes B2 geschaltet wird. Tritt ein Verfahrensabbruch auf, während das Flag gesetzt ist, werden bei erneuter Aufnahme des Verfahrens die Daten aus dem Pufferspeicher in die Datei geschrieben. Ist hingegen bei Auftreten des Verfahrensabbruchs das Flag gelöscht, werden bei erneuter Aufnahme des Verfahrens die in der Datei vorhandenen Daten beibehalten. Bei einem nachfolgenden neuen Schreibzyklus werden wiederum in einem ersten Schritt (5) die ursprünglichen Daten der Datei in den Pufferspeicher kopiert (Fig. 2, Fig. 3). Anschließend wird, in einem zweiten Schritt (6), das Flag des Pufferspeichers auf gültig gesetzt (Fig. 2). Dies kann beispielsweise durch einen Schaltvorgang (6) wie den in Zeile d) von Fig. 1 gezeigten durchgeführt werden, bei dem das zweite Bit des ersten Bitfeldes B1 geschaltet wird.

Bei einer bevorzugten Ausführungsform einer erfindungsgemäßen Speichereinrichtung mit einer Rücksetzeinrichtung weist die Speichereinrichtung weiter zusätzlich eine Rücksetz-Absicherungseinheit auf, die dazu eingerichtet ist, das Zustandskennzeichen auf Konsistenz gemäß einer vorbestimmten Struktur, die das Zustandskennzeichen hat, zu überprüfen. Mit der Rücksetz-Absicherungseinheit lässt sich verhindern, dass das Flag einen unbestimmten Zustand erlangt, wenn während des Betriebs, z.B. während des Setzens oder Rücksetzens, eine Unterbrechung auftritt, insbesondere eine Unterbrechung der Versorgungsspannung. Welcher Zustand des Zustandskennzeichens konsistent ist und welcher nicht, ist durch die Struktur des Zustandskennzeichens vorbestimmt.

Bei einem Zustandskennzeichen mit zwei Teilkennzeichen mit je mehreren logisch linear (z.B. wie in Fig. 1, Fig. 4, 5) angeordneten Speicherzellen umfasst die Konsistenz vorzugsweise, dass innerhalb jedes Teilkennzeichens höchstens ein einziges Paar von benachbarten Speicherzellen existiert, die unterschiedliche Zustandswerte haben. Auf diese Weise ist sichergestellt, dass die Speicherzellen derartige Werte haben, wie sie durch ein ordnungsgemäßes bitweises, sequentielles Schreiben erzeugt werden, bei dem benachbarte Speicherzellen innerhalb eines Teilkennzeichens der Reihe nach nacheinander (d.h. in einer Reihenfolge erste, zweite, dritte, etc. Speicherzelle) geschaltet werden.

Die Rücksetz-Absicherungseinheit ist vorzugsweise weiter dazu eingerichtet, ein Rücksetzen des Zustandskennzeichens auf den Ausgangswert zu veranlassen oder zu bewirken, wenn die Überprüfung fehlende Konsistenz ergibt. Falls das Rücksetzen bewirkt wird, sind vorzugsweise alle dafür erforderlichen Einrichtungen bei der Speichereinrichtung vorhanden, und dabei weiter vorzugsweise in einen Datenträger wie eine Chipkarte oder einen Token integriert. Falls das Rücksetzen lediglich veranlasst wird, ist wahlweise zumindest ein Teil der zum Bewirken des Rücksetzens erforderlichen Einrichtungen gesondert von der Speichereinrichtung vorgesehen und, falls die Speichereinrichtung in einen Datenträger wie eine Chipkarte oder einen Token integriert ist, außerhalb des Datenträgers vorgesehen.

Wenn also beispielsweise bei dem genannte Zustandskennzeichen mit zwei Teilkennzeichen mit je mehreren logisch linear angeordneten Speicherzellen innerhalb eines Teilkennzeichens (Bitfelds) mehrfach ein Wechsel des Speicherwerts auftaucht, d.h. mehrere Paare von benachbarten Speicherzellen mit unterschiedlichen Speicherwerten (z.B. "00101111", hat drei Paare von benachbarten Speicherzellen mit unterschiedlichen Speicherwerten; oder "00110000", hat zwei Paare von benachbarten Speicherzellen mit unterschiedlichen Speicherwerten), wird das Zustandskennzeichen als inkonsistent erkannt. Folglich wird das Zustandskennzeichen auf den Ausgangswert (z.B. "11111111") zurückgesetzt. Unter einer logisch linearen Anordnung der Speicherzellen wird verstanden, dass die Speicherzellen logisch gesehen nebeneinander liegen, so dass sie eine lineare Abfolge von Speicherzellen bilden, beispielsweise ein Speicherwort oder eine Mehrzahl von Speicherwörtern oder dergleichen, wobei die Speicherzellen physikalisch gesehen nicht notwendig nebeneinander liegen müssen.

Im Folgenden sind typische Parameterwerte für Programmierparameter wie Programmierdauer und/ oder Programmierspannung bei der erfindungsgemäßen Speichereinrichtung angegeben. Betreffend die Programmierdauer hat ein Schreibvorgang vorzugsweise eine Schreibdauer aus dem Bereich von ungefähr 1 bis ungefähr 20 µs, weiter vorzugsweise ungefähr typischerweise 7 µs und maximal 10 µs, und ein Löschvorgang eine Löschdauer aus dem Bereich von ungefähr 1 ms bis ungefähr 50 ms, weiter vorzugsweise ungefähr typischerweise 18 ms und maximal 25 ms, oder umgekehrt. Die Programmierspannung liegt vorzugsweise zum Schreiben im Spannungsbereich von 1V bis 4V, vorzugsweise bei ca. 3.0V bis 3.6V und zum Löschen im Spannungsbereich von 5V bis 16V, vorzugsweise bei ungefähr 10V, oder umgekehrt. Die Programmierspannung ist vorzugsweise gleich der an die einzelne Speicherzelle angelegten Spannung, die von der von außen angelegten Spannung unterschiedlich sein kann, wobei die an die Speicherzelle angelegte Spannung vorzugsweise in an sich bekannter Weise aus der von außen angelegten Spannung erzeugt wird. Die von außen angelegte Spannung ist beispielsweise die Ausgangsspannung einer Spannungsquelle. Die genannten Parameterwerte sind Beispielswerte. Abhängig vom verwendeten Speicher können die Parameterwerte auch in anderen Bereichen liegen.

## Patentansprüche

1. Speichereinrichtung mit
- einem elektronischen Speicher mit einer Mehrzahl von binären Speicherzellen, wobei jede Speicherzelle durch einen Programmiervorgang zwischen einem gelöschten und einem beschriebenen Zustand schaltbar ist, wobei durch einen Löschvorgang der gelöschte Zustand herstellbar ist und durch einen Schreibvorgang der beschriebene Zustand herstellbar ist, wobei der Speicher bezüglich Schreibvorgängen und Löschvorgängen asymmetrisch ist, wobei dies genauer bedeutet, dass bei einem Schreibvorgang ein oder mehrere Programmierparameter einen anderen Wert haben als bei einem Löschvorgang, wobei die Speichereinrichtung weiter ausgestattet ist mit
- mindestens einem in dem Speicher implementierten Zustandskennzeichen (Flag B1, B2), das wahlweise einen ersten, gesetzten Zustandswert oder einen zweiten, nicht gesetzten Zustandswert haben kann, wobei das Zustandskennzeichen (B1, B2) zumindest zwei Teilkennzeichen umfasst, und
- einer Schalteinrichtung, mit der der Wert des Zustandskennzeichens (B1, B2) zwischen dem ersten und dem zweiten Zustandswert schaltbar ist, wobei zum Schalten des Zustandswerts mindestens ein Programmiervorgang an mindestens einer Speicherzelle durchgeführt wird,
**dadurch gekennzeichnet, dass** die Schalteinrichtung derart implementiert ist, dass zum Schalten des Zustandskennzeichens (B1, B2) vom ersten zum zweiten Zustandswert und zum Schalten vom zweiten zum ersten Zustandswert in beiden Fällen die gleiche Art von Programmiervorgang, entweder Schreibvorgang oder Löschvorgang, durchgeführt wird.

2. Speichereinrichtung nach Anspruch 1, wobei die Asymmetrie bezüglich Schreibvorgängen und Löschvorgängen umfasst, dass ein Schreibvorgang eine kürzere Progrämmierdauer hat als ein Löschvorgang oder umgekehrt.

3. Speichereinrichtung nach Anspruch 1 oder 2, wobei von der Schalteinrichtung zum Schalten zwischen dem ersten und zweiten Zustandswert des Zustandskennzeichens (Flag B1, B2) derjenige Programmiervorgang von dem Schreibvorgang und dem Löschvorgang verwendet wird, der eine kürzere Programmierdauer hat.

4. Speichereinrichtung nach einem der Ansprüche 1 bis 3, wobei die Asymmetrie bezüglich Schreibvorgängen und Löschvorgängen umfasst, dass ein Schreibvorgang eine andere, insbesondere höhere oder niedrigere, Programmierspannung, insbesondere für den Programmiervorgang an der Speicherzelle, benötigt als ein Löschvorgang.

5. Speichereinrichtung nach einem der Ansprüche 1 bis 4, wobei das Zustandskennzeichen (B1, B2) mindestens ein Paar von zwei Teilkennzeichen (B1, B2) hat, wobei jedes Teilkennzeichen des Paars mindestens eine Speicherzelle aufweist.

6. Speichereinrichtung nach Anspruch 5, wobei jedes Teilkennzeichen (B1, B2) des Paars die gleiche Anzahl von Speicherzellen aufweist.

7. Speichereinrichtung nach Anspruch 5 oder 6, wobei der erste Zustandswert des Zustandskennzeichens (Flag B1, B2) **dadurch** ausgezeichnet ist, dass in jedem Teilkennzeichen des Paars von Teilkennzeichen (B1, B2) die gleiche Anzahl von Speicherzellen den gelöschten und/oder den beschriebenen Zustand hat, und wobei der zweite Zustandswert des Zustandskennzeichens (Flag B1, B2) **dadurch** ausgezeichnet ist, dass in jedem Teilkennzeichen des Paars von Teilkennzeichen (B1, B2) eine unterschiedliche Anzahl von Speicherzellen den gelöschten und/ oder den beschriebenen Zustand hat.

8. Speichereinrichtung nach einem der Ansprüche 5 bis 7, wobei der erste Zustandswert des Zustandskennzeichens (Flag B1, B2) **dadurch** ausgezeichnet ist, dass in den beiden Teilkennzeichen des Paars von Teilkennzeichen (B1, B2) korrespondierende Speicherzellen den gleichen Zustand haben, und der zweite Zustandswert des Zustandskennzeichens (Flag B1, B2) **dadurch** ausgezeichnet ist, dass für ein Paar von korrespondierenden Speicherzellen in den beiden Teilkennzeichen (B1, B2) die beiden korrespondierenden Speicherzellen voneinander unterschiedliche Zustände haben.

9. Speichereinrichtung nach einem der Ansprüche 5 bis 8, die eine, insbesondere in Softwareform und/ oder in Hardwareform implementierte, Logikeinheit, insbesondere XOR-Logikeinheit, aufweist, die dazu eingerichtet ist, korrespondierende Speicherzellen des ersten und des zweiten Teilkennzeichens (B1, B2) zu verknüpfen und das Ergebnis der Verknüpfung als Zustandswert des Zustandskennzeichens (B1, B2) auszugeben oder für die weitere Berechnung des Zustandswerts bereitzustellen.

10. Speichereinrichtung nach einem der Ansprüche 1 bis 9, die weiter eine Rücksetzeinrichtung aufweist, mit der ein Ausgangszustand des Zustandskennzeichens (B1, B2) einstellbar ist.

11. Speichereinrichtung nach Anspruch 10, wobei die Rücksetzeinrichtung derart implementiert ist, dass sie zum Einstellen des Ausgangszustands den anderen Programmiervorgang von dem Schreibvorgang und dem Löschvorgang verwendet, als er zum Schalten zwischen dem ersten und dem zweiten Zustandswert des Zustandskennzeichens (Flag B1, B2)) verwendet wird.

12. Speichereinrichtung nach Anspruch 10 oder 11, die weiter eine Rücksetz-Absicherungseinheit aufweist, die dazu eingerichtet ist, das Zustandskennzeichen (B1, B2) auf Konsistenz gemäß einer vorbestimmten Struktur, die das Zustandskennzeichen hat, zu überprüfen.

13. Speichereinrichtung nach Anspruch 12, wobei die Rücksetz-Absicherungseinheit dazu eingerichtet ist, ein Rücksetzen des Zustandskennzeichens (B1, B2) auf den Ausgangswert zu veranlassen oder zu bewirken, wenn die Überprüfung fehlende Konsistenz ergibt.

14. Speichereinrichtung nach Anspruch 12 oder 13, wobei bei einem Zustandskennzeichen (B1, B2) mit zwei Teilkennzeichen (B1, B2) mit je mehreren logisch linear angeordneten Speicherzellen die Konsistenz umfasst, dass innerhalb jedes Teilkennzeichens höchstens ein einziges Paar von benachbarten Speicherzellen existiert, die unterschiedliche Zustandswerte haben.

15. Datenträger, insbesondere Chipkarte oder Token, mit einem elektronischen Schaltkreis mit einer darin implementierten Speichereinrichtung nach einem der Ansprüche 1 bis 14.

16. Verfahren zum Kennzeichnen des Zustands eines Speicherabschnitts, der insbesondere eine Datei oder ein Datenfeld oder vergleichbaren Speicherinhalt enthält, mittels eines Zustandskennzeichens, bei welchem
- dem Speicherabschnitt eine Speichereinrichtung mit einem darin implementierten Zustandskennzeichen (B1, B2) bereitgestellt wird, und
+ einem elektronischen Speicher mit einer Mehrzahl von binären Speicherzellen, wobei jede Speicherzelle durch einen Programmiervorgang zwischen einem gelöschten und einem beschriebenen Zustand schaltbar ist, wobei durch einen Löschvorgang der gelöschte Zustand herstellbar ist und durch einen Schreibvorgang der beschriebene Zustand herstellbar ist, wobei der Speicher bezüglich Schreibvorgängen und Löschvorgängen asymmetrisch ist, wobei dies genauer bedeutet, dass bei einem Schreibvorgang ein oder mehrere Programmierparameter einen anderen Wert haben als bei einem Löschvorgang,
+ mindestens dem in dem Speicher implementierten Zustandskennzeichen (Flag B1, B2), das wahlweise einen ersten, gesetzten, Zustandswert oder einen zweiten, nicht gesetzten, Zustandswert haben kann, wobei das Zustandskennzeichen (B1, B2) zumindest zwei Teilkennzeichen umfasst, und
+ einer Schalteinrichtung, mit der der Wert des Zustandskennzeichens (B1, B2) zwischen dem ersten und dem zweiten Zustandswert schaltbar ist, wobei zum Schalten des Zustandswerts mindestens ein Programmiervorgang an mindestens einer Speicherzelle durchgeführt wird,
- in Abhängigkeit vom Zustand des Speicherabschnitts das Zustandskennzeichen (B1, B2) auf einen ersten Zustandswert oder einen zweiten Zustandswert geschaltet wird,
**dadurch gekennzeichnet dass** zum Schalten des Zustandskennzeichens (B1, B2) vom ersten zum zweiten Zustandswert und zum Schalten vom zweiten zum ersten Zustandswert in beiden Fällen dei gleiche Art von Programmiervorgang, insbesondere entweder Schreibvorgang oder Löschvorgang, durchgeführt wird.

17. Verfahren nach Anspruch 16, wobei nach einmaligem oder mehrmaligem Schalten das Zustandskennzeichen (B1, B2) auf einen Ausgangswert zurückgesetzt wird, wobei vorzugsweise das Rücksetzen mittels der anderen Art von Programmiervorgang von dem Schreibvorgang und dem löschvorgang durchgeführt wird, als er zum Schalten verwendet wird.

18. Verfahren nach Anspruch 17, wobei weiter eine Konsistenzprüfung durchgeführt wird, bei der das Zustandskennzeichen (B1, B2) auf Konsistenz gemäß einer vorbestimmten Struktur, die das Zustandskennzeichen (B1, B2) hat, überprüft wird.

19. Verfahren nach Anspruch 18, wobei, wenn die Konsistenzprüfung fehlende Konsistenz ergibt, ein Rücksetzen des Zustandskennzeichens (B1, B2) auf den Ausgangswert veranlasst oder bewirkt wird.

## Claims

1. A memory device having
- an electronic memory having a plurality of binary memory cells, each memory cell being switchable by a programming operation between an erased and a written state, the erased state being producible by an erase operation and the written state being producible by a write operation, the memory being asymmetric with regard to write operations and erase operations, whereby this means more precisely that one or more programming parameters have a different value upon a write operation than upon an erase operation, the memory device further being equipped with
- at least one state identifier (flag B 1, B2) implemented in the memory and having alternatively a first, set state value or a second, unset state value, the state identifier (B1, B2) comprising at least two partial identifiers, and
- a switching device for switching the value of the state identifier (B1, B2) between the first and second state values, whereby for switching the state value at least one programming operation is carried out on at least one memory cell,
**characterized in that** the switching device is implemented such that for switching the state identifier (B1, B2) from the first to the second state value and for switching from the second to the first state value, the same kind of programming operation, either write operation or erase operation, is carried out in both cases.

2. The memory device according to claim 1, wherein the asymmetry with regard to write operations and erase operations comprises that a write operation has a shorter programming time than an erase operation, or vice versa.

3. The memory device according to claim 1 or 2, wherein there is employed by the switching device for switching between the first and second state values of the state identifier (flag B1, B2) that programming operation of the write operation and erase operation that has a shorter programming time.

4. The memory device according to any of claims 1 to 3, wherein the asymmetry with regard to write operations and erase operations comprises that a write operation requires a different, in particular higher or lower, programming voltage, in particular for the programming operation on the memory cell, compared to an erase operation.

5. The memory device according to any of claims 1 to 4, wherein the state identifier (B1, B2) has at least one pair of two partial identifiers (B1, B2), each partial identifier of the pair having at least one memory cell.

6. The memory device according to claim 5, wherein each partial identifier (B1, B2) of the pair has the same number of memory cells.

7. The memory device according to claim 5 or 6, wherein the first state value of the state identifier (flag B1, B2) is **characterized in that** in each partial identifier of the pair of partial identifiers (B 1, B2) the same number of memory cells has the erased and/or the written state, and wherein the second state value of the state identifier (flag B1, B2) is **characterized in that** in each partial identifier of the pair of partial identifiers (B1, B2) a different number of memory cells has the erased and/or the written state.

8. The memory device according to any of claims 5 to 7, wherein the first state value of the state identifier (flag B 1, B2) is **characterized in that** corresponding memory cells have the same state in both partial identifiers of the pair of partial identifiers (B1, B2), and the second state value of the state identifier (flag B1, B2) is **characterized in that** for a pair of corresponding memory cells the two corresponding memory cells have mutually different states in both partial identifiers (B1, B2).

9. The memory device according to any of claims 5 to 8, which has a logic unit, in particular XOR logic unit, implemented in particular in software form and/or in hardware form, which is adapted to combine corresponding memory cells of the first and second partial identifiers (B1, B2) and to output the result of the combination as a state value of the state identifier (B1, B2) or to make it available for further computation of the state value.

10. The memory device according to any of claims 1 to 9, which further has a reset device for setting an initial state of the state identifier (B1, B2).

11. The memory device according to claim 10, wherein the reset device is implemented such that for setting the initial state it employs the other programming operation of the write operation and erase operation as is employed for switching between the first and second state values of the state identifier (flag B1, B2).

12. The memory device according to claim 10 or 11, which further has a reset protection unit which is adapted to check the state identifier (B1, B2) for consistency according to a predetermined structure which the state identifier has.

13. The memory device according to claim 12, wherein the reset protection unit is adapted to initiate or to cause a reset of the state identifier (B1, B2) to the initial value when the check yields a lack of consistency.

14. The memory device according to claim 12 or 13, wherein, for a state identifier (B1, B2) with two partial identifiers (B1, B2) each with a plurality of logically linearly disposed memory cells, the consistency comprises that no more than a single pair of neighboring memory cells having different state values exists within each partial identifier.

15. A data carrier, in particular chip card or token, having an electronic circuit with a memory device implemented therein according to any of claims 1 to 14.

16. A method for identifying the state of a memory section containing in particular a file or a data field or comparable memory contents, by means of a state identifier, wherein
- there is made available to the memory section a memory device having a state identifier (B1, B2) implemented therein, and
+ an electronic memory having a plurality of binary memory cells, each memory cell being switchable by a programming operation between an erased and a written state, the erased state being producible by an erase operation and the written state being producible by a write operation, the memory being asymmetric with regard to write operations and erase operations, whereby this means more precisely that one or more programming parameters have a different value upon a write operation than upon an erase operation,
+ at least the state identifier (flag B1, B2) implemented in the memory and having alternatively a first, set state value or a second, unset state value, the state identifier (B1, B2) comprising at least two partial identifiers, and + a switching device for switching the value of the state identifier (B1, B2) between the first and second state values, whereby for switching the state value at least one programming operation is carried out on at least one memory cell,
- as a function of the state of the memory section the state identifier (B1, B2) is switched to a first state value or a second state value,
**characterized in that** for switching the state identifier (B1, B2) from the first to the second state value and for switching from the second to the first state value the same kind of programming operation, in particular either write operation or erase operation, is carried out in both cases.

17. The method according to claim 16, wherein the state identifier (B1, B2) is reset to an initial value after one or more switchings, the reset preferably being carried out by means of the other kind of programming operation of the write operation and erase operation as is employed for switching.

18. The method according to claim 17, wherein further a consistency check is carried out wherein the state identifier (B1, B2) is checked for consistency according to a predetermined structure which the state identifier (B1, B2) has.

19. The method according to claim 18, wherein a reset of the state identifier (B1, B2) to the initial value is initiated or caused when the consistency check yields a lack of consistency.

## Revendications

1. Dispositif de mémoire avec
- une mémoire électronique comportant une pluralité de cellules de mémoire binaires, chaque cellule de mémoire étant, par un processus de programmation, commutable entre un état dans lequel les données sont effacées et un état dans lequel les données figurent, l'état dans lequel les données sont effacées pouvant être produit par un processus d'effacement et l'état dans lequel les données figurent pouvant être produit par un processus d'écriture, la mémoire étant asymétrique quant aux processus d'effacement et aux processus d'écriture, cela signifiant plus précisément qu'un ou plusieurs paramètres de programmation ont une autre valeur lors d'un processus d'écriture que lors d'un processus d'effacement,
le dispositif de mémoire étant en outre équipé de
- au moins un indicateur d'état (Flag B1, B2) implémenté dans la mémoire, qui peut avoir au choix une première valeur d'état positionnée ou une deuxième valeur d'état non positionnée, l'indicateur d'état (B1, B2) comprenant au moins deux indicateurs partiels, et
- un dispositif de commutation, avec laquelle la valeur de l'indicateur d'état (B1, B2) est commutable entre la première et la deuxième valeur d'état, au moins un processus de programmation étant effectué à au moins une cellule de mémoire pour commuter la valeur d'état,
**caractérisé en ce que** le dispositif de commutation est implémenté de telle sorte que, pour commuter l'indicateur d'état (B1, B2) de la première à la deuxième valeur d'état et pour commuter de la deuxième à la première valeur d'état, le même mode de processus de programmation, soit processus d'écriture, soit processus d'effacement, est effectué dans les deux cas.

2. Dispositif de mémoire selon la revendication 1, l'asymétrie relative aux processus d'écriture et processus d'effacement incluant qu'un processus d'écriture a une durée de programmation plus courte qu'un processus d'effacement ou inversement.

3. Dispositif de mémoire selon la revendication 1 ou 2, le processus de programmation du processus d'écriture et du processus d'effacement utilisé par le dispositif de mémoire pour commuter entre la première et la deuxième valeur d'état de l'indicateur d'état (Flag B1, B2) étant celui qui a une durée de programmation plus courte.

4. Dispositif de mémoire selon une des revendications de 1 à 3, l'asymétrie relative aux processus d'écriture et processus d'effacement incluant qu'un processus d'écriture a besoin d'une autre tension, notamment d'une tension plus élevée ou plus basse, qu'un processus d'effacement, notamment pour le processus de programmation à la cellule de mémoire.

5. Dispositif de mémoire selon une des revendications de 1 à 4, l'indicateur d'état (B1, B2) ayant au moins une paire de deux indicateurs partiels (B1, B2), chaque indicateur partiel de la paire comportant au moins une cellule de mémoire.

6. Dispositif de mémoire selon la revendication 5, chaque indicateur partiel (B1, B2) de la paire ayant le même nombre de cellules de mémoire.

7. Dispositif de mémoire selon la revendication 5 ou 6, la première valeur d'état de l'indicateur d'état (Flag B1, B2) se distinguant par le fait que, dans chaque indicateur partiel de la paire d'indicateurs partiels (B1, B2), le même nombre de cellules de mémoire a l'état dans lequel les données sont effacées et / ou l'état dans lequel les données figurent, et la deuxième valeur d'état de l'indicateur d'état (Flag B1, B2) se distinguant par le fait que, dans chaque indicateur partiel de la paire d'indicateurs partiels (B1, B2), un nombre différent de cellules de mémoire a l'état dans lequel les données sont effacées et / ou l'état dans lequel les données figurent.

8. Dispositif de mémoire selon une des revendications de 5 à 7, la première valeur d'état de l'indicateur d'état (Flag B1, B2) se distinguant par le fait que, dans les deux indicateurs partiels de la paire d'indicateurs partiels (B1, B2), des cellules de mémoire correspondantes ont le même état, et la deuxième valeur d'état de l'indicateur d'état (Flag B1, B2) se distinguant par le fait que, pour une paire de cellules de mémoire correspondantes dans les deux indicateurs partiels (B1, B2), les deux cellules de mémoire correspondantes ont des états différents l'un de l'autre.

9. Dispositif de mémoire selon une des revendications de 5 à 8, qui comporte un boîtier logique notamment implémenté sous forme de logiciel et / ou sous forme de matériel, notamment un boîtier logique XOR, qui est équipé pour chaîner des cellules de mémoire correspondantes du premier et du deuxième indicateur partiel (B1, B2) et délivrer le résultat du chaînage en tant que valeur d'état de l'indicateur d'état (B1, B2) ou mettre à disposition le résultat du chaînage pour la poursuite du calcul de la valeur d'état.

10. Dispositif de mémoire selon une des revendications de 1 à 9, qui comporte en outre un dispositif de réinitialisation, avec lequel un état initial de l'indicateur d'état (B1, B2) est réglable.

11. Dispositif de mémoire selon la revendication 10, le dispositif de réinitialisation étant implémenté de telle façon que, pour régler l'état initial, il utilise l'autre processus de programmation du processus d'écriture et du processus d'effacement, et non celui qui est utilisé pour commuter entre la première et la deuxième valeur d'état de l'indicateur d'état (Flag B1, B2).

12. Dispositif de mémoire selon la revendication 10 ou 11, qui comporte en outre une unité de protection de réinitialisation équipée pour vérifier l'indicateur d'état (B1, B2) quant à sa consistance en fonction d'une structure prédéterminée qu'a l'indicateur d'état.

13. Dispositif de mémoire selon la revendication 12, l'unité de protection de réinitialisation étant équipée pour entraîner ou pour occasionner une remise de l'indicateur d'état (B1, B2) à la valeur initiale quand la vérification décèle une consistance manquante.

14. Dispositif de mémoire selon la revendication 12 ou 13, la consistance comprenant, dans le cas d'un indicateur d'état (B1, B2) comportant deux indicateurs partiels (B1, B2) avec chacun plusieurs cellules de mémoire disposées de manière linéaire logique, qu'au maximum une seule paire de cellules de mémoire voisines ayant des valeurs d'état différentes existe à l'intérieur de chaque indicateur partiel.

15. Support de données, notamment carte à puce ou jeton, comportant un circuit électronique avec un dispositif de mémoire y étant implémenté selon une des revendications de 1 à 14.

16. Procédé d'indication de l'état d'une portion de mémoire contenant notamment un fichier ou un champ de données ou un contenu de mémoire similaire, au moyen d'un indicateur d'état, dans lequel
- un dispositif de mémoire avec un indicateur d'état (B1, B2) y étant implémenté est mis à la disposition de la portion de mémoire, et
+ au moyen d'une mémoire électronique comportant une pluralité de cellules de mémoire binaires, chaque cellule de mémoire étant, par un processus de programmation, commutable entre un état dans lequel les données sont effacées et un état dans lequel les données figurent, l'état dans lequel les données sont effacées pouvant être produit par un processus d'effacement et l'état dans lequel les données figurent pouvant être produit par un processus d'écriture, la mémoire étant asymétrique quant aux processus d'effacement et aux processus d'écriture, cela signifiant plus précisément qu'un ou plusieurs paramètres de programmation ont une autre valeur lors d'un processus d'écriture que lors d'un processus d'effacement,
+ au moyen d'au moins l'indicateur d'état (Flag B1, B2) implémenté dans la mémoire, qui peut avoir au choix une première valeur d'état positionnée ou une deuxième valeur d'état non positionnée, l'indicateur d'état (B1, B2) comprenant au moins deux indicateurs partiels, et
+ au moyen d'un dispositif de commutation, avec lequelle la valeur de l'indicateur d'état (B1, B2) est commutable entre la première et la deuxième valeur d'état, au moins un processus de programmation étant effectué à au moins une cellule de mémoire pour commuter la valeur d'état,
- dans lequel, en fonction de l'état de la portion de mémoire, l'indicateur d'état (B1, B2) est commuté sur une première valeur d'état ou sur une deuxième valeur d'état,
**caractérisé en ce que**, pour commuter l'indicateur d'état (B1, B2) de la première à la deuxième valeur d'état et pour commuter de la deuxième à la première valeur d'état, le même mode de processus de programmation, notamment soit le processus d'écriture, soit le processus d'effacement, est effectué dans les deux cas.

17. Procédé selon la revendication 16, l'indicateur d'état (B1, B2) étant remis à une valeur initiale après commutation unique ou réitérée, la remise étant effectuée de préférence au moyen de l'autre mode de processus de programmation du processus d'écriture et du processus d'effacement, et non au moyen de celui qui est utilisé pour commuter.

18. Procédé selon la revendication 17, une vérification de consistance étant en outre effectuée, lors de laquelle l'indicateur d'état (B1, B2) est vérifié quant à sa consistance en fonction d'une structure prédéterminée qu'a l'indicateur d'état (B1, B2).

19. Procédé selon la revendication 18, une remise de l'indicateur d'état (B1, B2) à la valeur initiale étant entraînée ou occasionnée quand la vérification de consistance décèle une consistance manquante.
